(19) Europäisches Patentamt European Patent Office Office européen des brevets

(11) **EP 2 319 039 B1**

(12) **FASCICULE DE BREVET EUROPEEN**

(45) Date de publication et mention de la délivrance du brevet:
**29.11.2017 Bulletin 2017/48**

(21) Numéro de dépôt: **09802567.9**

(22) Date de dépôt: **03.07.2009**

(51) Int Cl.:
*G10L 19/02* *(2013.01)*       *H03H 17/02* *(2006.01)*

(86) Numéro de dépôt international:
**PCT/FR2009/051302**

(87) Numéro de publication internationale:
**WO 2010/012925 (04.02.2010 Gazette 2010/05)**

(54) **PROCEDE DE MISE A JOUR D'UN CODEUR PAR INTERPOLATION DE FILTRE**

VERFAHREN ZUR AKTUALISIERUNG EINES KODIERERS MITTELS FILTERINTERPOLATION

METHOD FOR UPDATING AN ENCODER BY FILTER INTERPOLATION

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **29.07.2008 FR 0855228**

(43) Date de publication de la demande:
**11.05.2011 Bulletin 2011/19**

(73) Titulaire: **Orange**
**75015 Paris (FR)**

(72) Inventeurs:
• **PHILIPPE, Pierrick**
**35520 Melesse (FR)**
• **VIRETTE, David**
**22560 Pleumeur Bodou (FR)**

(74) Mandataire: **Cabinet Plasseraud**
**66, rue de la Chaussée d'Antin**
**75440 Paris Cedex 09 (FR)**

(56) Documents cités:
**FR-A- 2 828 600**

• **MARTUCCI S A: "Interpolation in the DST and DCT domains" IMAGE PROCESSING, 2000. PROCEEDINGS. 2000 INTERNATIONAL CONFERENCE ON SEPTEMBER 10-13, 2000, PISCATAWAY, NJ, USA,IEEE, vol. 2, 10 septembre 2000 (2000-09-10), pages 339-342, XP010529993 ISBN: 978-0-7803-6297-0**
• **PINCHON D ET AL: "Design Techniques for Orthogonal Modulated Filterbanks Based on a Compact Representation" IEEE TRANSACTIONS ON SIGNAL PROCESSING, IEEE SERVICE CENTER, NEW YORK, NY, US, vol. 52, no. 6, 1 juin 2004 (2004-06-01), pages 1682-1692, XP011113062 ISSN: 1053-587X**

**Description**

La présente invention concerne un traitement de signal, notamment un signal audio (tel un signal de parole) et/ou vidéo, sous forme d'une succession d'échantillons. Elle concerne en particulier un traitement de signal par transformée et se rapporte notamment au domaine des transformées modulées.

Les transformées modulées trouvent leur application dans l'analyse et la transmission des signaux numérisés (sous la forme donc d'une succession d'échantillons espacés dans le temps d'une période d'échantillonnage). Elles trouvent également leur application dans la synthèse de signaux. A titre d'exemple, le codage d'un signal peut faire intervenir un banc de filtres d'analyse, une quantification, et un banc de filtres de synthèse.

Pour les transformées modulées, on définit habituellement des filtres appelés « prototypes » qui sont modulés selon différentes valeurs en fréquence. De cette manière, on dispose d'un ensemble de canaux permettant de représenter le signal à différentes positions dites « fréquentielles ».

Les modulations peuvent être réalisées par une opération du type: $h_k(n) = h(n) \cdot W(k,n)$, où:

- $n$ est un indice temporel correspondant à un multiple de la période d'échantillonnage,

- $k$ est un indice représentant un canal fréquentiel considéré, et

- $L$ est la longueur du filtre (et de la modulation).

En outre, dans l'expression ci-dessus :

- $h(n)$ (avec $0 \leq n < L$) définit le filtre prototype pouvant avoir une valeur complexe,

- $W(k,n)$ (avec $0 \leq n < L$) définit la fonction modulante pour le canal $k$ qui peut être aussi à valeurs complexes,

- $h_k(n)$ (avec $0 \leq n < L$) définit le filtre modulé pour le canal $k$.

Pour procéder à l'analyse d'un signal par exemple à coder, on projette le signal $x(n)$ à analyser sur le filtre modulé par une opération de produit scalaire :

$$y_k = \langle x, h_k \rangle = \sum_{n=0}^{L-1} x(n) \cdot h_k(n).$$

Les signaux analysés peuvent être le résultat de plusieurs projections, par exemple sous la forme : $y_k = \langle x, h_k \rangle + \lambda \langle x, h'_j \rangle$, où $\lambda$, $h'_j$ et $j$ sont respectivement un gain, une modulation et un indice fréquentiel, ces derniers pouvant être différents de $h_k$ et $k$.

Ces opérations d'analyse peuvent être succédées dans le temps, donnant lieu à une série de signaux $y_k$ évoluant dans le temps.

On peut ainsi écrire:

$$y_{k,m} = \langle x_m, h_k \rangle = \sum_{n=0}^{L-1} x(n+mT) \cdot h_k(n) \quad,$$

m désignant un indice de blocs d'échantillons successifs (ou « trame ») et $T$ définissant la durée d'une trame (en nombre d'échantillons).

Les transformées modulées trouvent également leur application dans la synthèse de signaux. Pour ce type d'application, un contenu sera généré dans un certain nombre de canaux fréquentiels et ces canaux seront assemblés pour restituer un signal numérique.

Un signal $\hat{x}(n)$ est ainsi synthétisé par projection des signaux transformés $y_k$ sur les $M$ vecteurs de synthèse. On définit d'abord une expression $\hat{x}(n)$ telle que :

$$\tilde{x}(n) = \langle y, h_k \rangle = \sum_{k=0}^{M-1} y_k \cdot h_k(n) \text{ pour } 0 \leq n < L.$$

Les signaux $y_k$ peuvent évoluer dans le temps, de sorte que la synthèse permettra ainsi de générer un signal d'une longueur arbitraire :

$$\tilde{x}(n+mT) = \langle y_m, h_k \rangle = \sum_{k=0}^{M-1} y_{k,m} \cdot h_k(n) \text{ pour } 0 \le n < L.$$

Les vecteurs définis par les expressions $\tilde{x}$, pour $0 \le n < L$, sont décalés de $M$ échantillons puis additionnés entre eux, pour donner un signal synthétisé $\hat{x}$. On parle d'opération dite « d'addition avec recouvrement ».

Les transformées modulées trouvent avantageusement une application en codage des signaux.

Dans les systèmes de codage en fréquence, on procède à une transformée d'analyse au moyen de filtres d'analyse modulés $h_k$ avec :

$$y_{k,m} = \langle x_m, h_k \rangle = \sum_{n=0}^{L-1} x(n+mT) \cdot h_k(n).$$

Les signaux $y_{k,m}$, porteurs d'information utile (l'utilité pouvant être jugée par exemple au travers d'un critère de distorsion perceptif), sont alors approximés et transmis sous une forme codée.

Au niveau du décodeur, les composantes $y_{k,m}$ approximées reçues sont synthétisées par la transformation inverse pour restituer une approximation des échantillons originaux.

La synthèse est réalisée au moyen d'un ensemble de filtres modulés de synthèse $f_k$:

$$\tilde{x}(n+mT) = \langle y_m, f_k \rangle = \sum_{k=0}^{M-1} y_{k,m} \cdot f_k(n)$$

Puis, on procède à l'opération d'addition recouvrement pour obtenir un signal reconstruit et décodée $\hat{x}$.

Une classe de transformations modulées intéressantes est définie par les transformations à reconstruction parfaite.

Ces transformations permettent d'obtenir, au décodage, un signal décodé correspondant sensiblement, voire parfaitement dans le cas de la reconstruction parfaite, au signal initial lorsque les composantes $y_k$ transformées ne sont pas modifiées, et ce moyennant un retard $R$, soit : $\hat{x}(n) = x(n - R)$.

La reconstruction peut également être à reconstruction « quasi-parfaite » lorsque la différence entre les signaux reconstruits $x$ et $\hat{x}$ peut être considérée négligeable. Par exemple, en codage audio, une différence ayant une puissance d'erreur 50 dB plus faible que la puissance du signal $x$ traité peut être considérée comme négligeable.

Les transformations les plus utilisées sont de type "ELT" (pour "Extended Lapped Transforms") qui assurent la reconstruction parfaite et qui utilisent un filtre de longueur $L = 2 \cdot K \cdot M$. Les transformations en Cosinus Discret Modifié ou "MDCT" (pour "Modified Discrète Cosine Transform"), de type « MLT » (pour « Modulated Lapped Transform »), en sont un cas particulier avec $K = 1$.

Les filtres miroirs en quadrature (ou «QMF»), ou encore les filtres PQMF (pour « Pseudo Quadrature Mirror Filter »), sont une solution à reconstruction quasi-parfaite utilisant des termes de modulation différents.

Ces différentes transformées peuvent être à coefficients réels ou complexes. Elles peuvent faire usage de filtre prototypes symétriques ou non.

Afin de satisfaire la condition de reconstruction parfaite ou quasi parfaite, pour toute forme de signal traité, les filtres modulés d'analyse et de synthèse doivent être liés les uns aux autres. Ainsi, des relations lient les termes de modulation et les filtres prototypes utilisés à l'analyse et à la synthèse. Par exemple, dans les systèmes à cosinus modulés (MDCT, ELT, PQMF, ou autres), les termes de modulation à l'analyse et à la synthèse sont liés, par exemple sous la forme: $W(k,n) = W'(k,n+\varphi)$, $W$ et $W'$ désignant respectivement les modulations utilisées à l'analyse et à la synthèse et $\varphi$ désignant un terme de déphasage.

Un cas particulier, communément utilisé, est défini par $\varphi = 0$. Les modulations sont alors identiques à l'analyse et à la synthèse.

Les filtres prototypes d'analyse et de synthèse peuvent également être liés entre eux pour assurer une reconstruction (quasi-)parfaite, avec une contrainte du type suivant, souvent employée : $h(L-1-n) = f(n)$, où $h$ et $f$ sont les filtres prototypes utilisés à l'analyse et à la synthèse.

Les modulations $W$ sont contraintes pour permettre d'assurer la reconstruction parfaite. Par exemple, on peut choisir communément pour les transformées ELT :

$$W(k,n) = \cos\left[\frac{\pi}{M}\left(n + \left(\frac{1+M}{2}\right)\right)\left(k + \frac{1}{2}\right)\right],$$

où $0 \leq n < L$ et $0 \leq k < M$, avec $L = 2 \cdot K \cdot M$.

De même, les filtres prototypes sont contraints afin d'assurer la reconstruction parfaite, avec, par exemple, une contrainte du type :

$$\sum_{i=0}^{2K-2s-1} f(n+iM)h(n+iM+2sM) = \delta(s), \text{ pour } s = 0,1,\ldots,K-1.$$

On peut notamment choisir les filtres prototypes parmi:

- ceux définis analytiquement sous la forme d'une équation et, dans cette classe, un filtre communément utilisé pour

$$h(n) = f(n) = \sin\left[\frac{\pi}{2M}(n+0.5)\right],$$

la transformée MDCT (avec $K=1$) s'exprime par: avec $0 \leq n < L$ où $L = 2 \cdot M$ ;

- les filtres résultant d'une optimisation numérique selon un critère qui ne permet pas de déduire une fonction analytique, tels que, par exemple, un filtre qui peut être obtenu en minimisant une quantité sous la contrainte de reconstruction parfaite (cette quantité pouvant être une atténuation en bande coupée à partir d'une fréquence de coupure, ou encore un gain de codage ou plus généralement tout autre quantité jugée pertinente pour la qualité de codage).

Comme évoqué précédemment, les filtres prototypes peuvent être symétriques ou non, la relation de symétrie s'écrivant :

$$h(L-1-n) = h(n).$$

La modélisation de la mise en oeuvre des transformations modulées décrite ci-avant est donnée à titre explicatif. Dans les implémentations matérielles de ces transformées, tous les calculs décrits ci-avant ne sont pas effectuées dans cette forme. Pour des raisons d'efficacité de calcul, de temps de calcul, et d'utilisation de ressources de calcul, on prévoit des implémentations dites « rapides ». Ces implémentations ne reprennent pas explicitement les calculs présentés ci-avant, ces calculs étant par ailleurs valables.

Les transformations modulées telles que présentées dans la suite, sont définies par des algorithmes rapides permettant une mise en oeuvre efficace par des moyens de calcul. Ces algorithmes reposent sur des transformées de Fourier rapides ou dérivées de celles-ci, telles que les transformations en cosinus ou en sinus rapides (par exemple des transformées DCT dites « de type 4 »).

Un ordre de transformation pour l'algorithme rapide inférieur ou égal au nombre $M$ de composantes fréquentielles est suffisant pour l'implémentation de ces transformations. Par ailleurs, ces transformations sont efficaces car leur complexité est proportionnelle au $\log_2(M)$ du nombre M de composantes.

Une opération de réduction de $L$ échantillons vers un nombre inférieur ou égal à $M$ composantes est appliquée en amont de la transformation rapide.

Un algorithme complet de la transformation à l'analyse peut combiner :

- une multiplication des échantillons de taille L par le filtre prototype,

- une combinaison du résultat de cette multiplication, c'est-à-dire une combinaison linéaire basée sur des multiplications de coefficients et des additions, permettant de déduire des L valeurs pondérées un nombre inférieur ou égal à M de composantes,

- une transformation rapide d'ordre inférieur ou égal à $M$

Ces opérations sont effectuées dans un ordre inversé pour effectuer la transformation de synthèse.

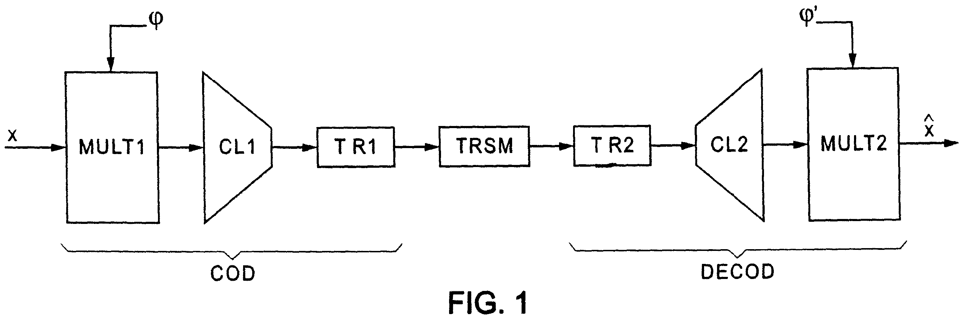

La figure 1 illustre l'analyse et la synthèse telle que décrite précédemment. Le signal x est présenté à un codeur COD comportant un filtre prototype $\varphi$. Un ensemble d'échantillons de taille L du signal sont ensuite multipliés par le filtre prototype dans le module MULT1. On réalise alors, dans le module CL1, une combinaison linéaire des échantillons multipliés par le filtre prototype afin de passer des L échantillons aux M composantes. On réalise alors une transformation rapide TR1, avant de transmettre les échantillons vers un décodeur DECOD.

Dès la réception des échantillons, le décodeur applique une transformation rapide TR2. Puis, à l'inverse de ce qui a été fait dans le codeur, on commence par réaliser une combinaison linéaire CL2 pour passer au nombre initial L d'échantillons. Ces échantillons sont ensuite multipliés par le filtre prototype du décodeur DECOD afin de reconstituer un signal $\tilde{x}$ à partir duquel, par opération d'addition recouvrement on obtient le signal $\hat{x}$.

Les coefficients du filtre prototype, du codeur ou du décodeur, doivent être stockés en mémoire afin de réaliser la transformée d'analyse ou de synthèse. Bien entendu, dans un système particulier utilisant des transformées modulées de tailles différentes, le filtre prototype pour chacune des tailles utilisées doit être représenté en mémoire.

Dans le cas favorable où les filtres sont symétriques, seuls $L/2$ coefficients ont besoin d'être stockés, les $L/2$ autres se déduisant sans opération arithmétique de ces coefficients stockés. Ainsi, pour une MDCT ($K=1$), si on a besoin d'une transformée de taille M et 2.M alors il faut stocker $(M+2M)=3M$ coefficients si les prototypes sont symétriques et $(2M+4M)=6M$ sinon. Un exemple typique pour le codage audio est $M=320$ ou $M=1024$. Ainsi, pour le cas asymétrique cela impose le stockage de 1920 et 6144 coefficients respectivement.

Selon la précision souhaitée pour la représentation des coefficients, 16 bits voire 24 bits pour chaque coefficient sont nécessaires. Cela implique un espace mémoire non négligeable pour des calculateurs de bas coût.

Si on dispose du filtre prototype pour une transformée de taille $UM$ alors il est possible d'obtenir les coefficients pour la transformée de taille $M$ par décimation. Classiquement, cela consiste à prélever un coefficient de filtre sur $U$ dans cet exemple précis.

En revanche si on dispose uniquement d'un filtre pour la transformation de taille $M$, il est beaucoup moins simple d'étendre ce filtre pour une utilisation à $MU$ coefficients. Une méthode directe d'interpolation polynomiale ne permet pas de conserver la précision de reconstruction du niveau de celle obtenue pour la transformation de base taille $M$. Ce type de méthode n'est donc pas optimal.

Lorsqu'un système de codage coeur est implémenté dans un codeur, il peut être utile de l'étendre, par exemple dans le cas d'une mise à jour d'une version normalisée du système de codage. Par exemple, les codeurs normalisés ITU G.718 et ITU G.729.1 font appel tous les deux à des transformées modulées MDCT de tailles respectives $M=320$ et $M=160$. Dans une extension de ces normes, afin d'opérer ces codeurs à une fréquence d'échantillonnage plus élevée, on parle alors d'extension *super wide band,* des MDCT de tailles supérieures sont nécessaires. Une MDCT de taille $M'=640$ doit être appliquée dans cette extension.

Dans une extension selon l'art antérieur, il faudrait étendre la quantité de stockage pour exprimer des coefficients d'un nouveau filtre prototype. De plus, il serait nécessaire de prévoir une intervention sur le codeur pour enregistrer les coefficients.

Le document FR-A-2 828 600 décrit un procédé de détermination de coefficients de filtrage d'un banc de filtres modulé, basé sur un filtre prototype de longueur L destiné à produire un système modulé à M sous-bandes.

Le document « Interpolation in the DST and DCT domains » MARTUCCI S A, XP010529993 présente des propriétés d'interpolation des transformées sinus et cosinus discrètes.

Le document « Design Techniques for Orthogonal Modulated Filterbanks based on a Compact Representation » PINCHON D ET AL, XP011113062 décrit un procédé de reconstruction parfaite d'un banc de filtres ayant un grand nombre de sous-bandes

La présente invention vient améliorer la situation, en proposant un moyen d'économiser de la mémoire, à la fois en ROM pour le stockage de coefficients, et/ou en RAM pour le calcul de la transformation.

On propose à cet effet un procédé de mise à jour de la capacité de traitement d'un codeur ou décodeur pour mettre en oeuvre une transformée modulée de taille supérieure à une taille prédéterminée, un tel codeur ou décodeur comportant une unité de traitement de signal numérique adaptée pour stocker un filtre prototype initial défini par un ensemble ordonné de coefficients de la taille initiale. On prévoit une étape de construction d'un filtre prototype de taille supérieure à la taille initiale pour mettre en oeuvre la transformée modulée de taille supérieure à la taille prédéterminée, par insertion d'au moins un coefficient entre deux coefficients consécutifs du filtre prototype initial.

Ainsi, au lieu de stocker des coefficients additionnels pour la transformation, on propose d'utiliser les coefficients déjà présents dans le codeur.

De cette manière, il est possible de définir une transformation de taille $UM$ en ne stockant qu'un seul filtre prototype conçu pour une transformation de taille $M$.

Bien entendu, les coefficients additionnels peuvent être utilisés à l'analyse ou à la synthèse ou aux deux extrémités d'une chaîne de traitement.

L'invention trouve une application avantageuse dans les systèmes embarqués, dans lesquels le prix de la mémoire représente une part importante du coût du système. Par exemple, en téléphonie mobile dans laquelle la consommation, la miniaturisation et le prix des codeurs/décodeurs implémentés doivent être optimisés. La réduction d'espace mémoire apportée par l'invention permet cette optimisation.

On entend par « mise à jour » le passage d'un état initial d'un codeur/décodeur en fonctionnement vers un état suivant différent. Mais l'invention se rapporte également à l'initialisation d'un codeur/décodeur qui n'a pas encore été mis en oeuvre pour un codage/décodage.

Avantageusement, les coefficients insérés sont calculés à partir des coefficients du filtre initial.

Par exemple, on peut prévoir que le coefficient inséré entre les deux coefficients consécutifs, est calculé par pondération d'au moins les deux coefficients consécutifs.

En outre on peut prévoir un procédé dans lequel le filtre prototype initial vérifie une relation de reconstruction prédéterminée, par exemple une relation de reconstruction parfaite. Dans ce cas, on réalise la pondération au moyen d'au moins une fonction de pondération calculée à partir de la relation de reconstruction.

En effet, il faut veiller à ce que les coefficients ajoutés permettent encore le bon fonctionnement du codeur. Ainsi, on prévoit une détermination des coefficients additionnels qui se fonde sur une pondération des coefficients du prototype initial et qui permet une transformation à reconstruction parfaite ou quasi parfaite.

Dans des modes de réalisation particuliers, la fonction de pondération est calculée pour chaque position, entre les deux coefficients consécutifs, du coefficient inséré.

Selon un mode de réalisation du procédé, la taille du filtre construit h' est U fois plus grande que la taille M du filtre initial h, avec U et M des entiers naturels strictement supérieurs à un. Dans ce cas, on définit une valeur de décalage S telle que $0 \leq S < U$, S étant un entier naturel et les filtres construit et initial vérifient la relation: $h'(U \times n + S) = h(n)$, pour tout entier naturel n tel que $0 \leq n < M$.

On peut en outre définir, pour tout entier naturel $\delta$ vérifiant $0 < \delta < U$ deux fonctions de pondération $P_\delta$ et $Q_\delta$. Ainsi, on définit les coefficients insérés par la relation: $h'(U \times n + S + \delta) = P_\delta(n) \times h(n) + Q_\delta(n) \times h(n+1)$, pour un entier n $n < M$.

On peut aussi prévoir que les deux fonctions de pondération sont égales. Enfin, on peut prévoir d'étendre le filtre prototype initial par symétrie, antisymétrie, ou ajout de coefficients nuls. Ces dispositions peuvent être utiles pour définir des coefficients manquant dans le filtre initial pour construire le filtre prototype.

On comprendra que la construction de filtre prototype proposée par l'invention, permet une réduction additionnelle du nombre de coefficients lorsque le filtre prototype initial contient des zéros. La fenêtre interpolée aura alors des zéros dans sa réponse impulsionnelle et des plages comprenant des coefficients égaux. L'espace mémoire nécessaire sera donc encore réduit.

Selon le schéma d'interpolation de pondération utilisé, le procédé décrit ci-avant permet d'obtenir des filtres prototypes ayant des réponses fréquentielles intéressantes dans la bande passante.

La présente invention prévoit en outre, un programme informatique comportant des instructions pour la mise en oeuvre du procédé décrit ci-avant lorsque ce programme est exécuté par un processeur. Elle prévoit également un support lisible par un ordinateur sur lequel est enregistré un tel programme d'ordinateur.

La présente invention prévoit également un codeur et un décodeur adaptés pour mettre en oeuvre le procédé décrit ci-avant.

Un codeur/décodeur selon la présente invention, comporte au moins deux zones mémoires, une première zone mémoire pour stocker un premier ensemble de coefficients définissant un filtre prototype initial de taille donnée, et une deuxième zone mémoire pour stocker un programme informatique comportant des instructions pour délivrer un deuxième ensemble de coefficients déterminés à partir des coefficients du premier ensemble. L'ensemble formé par l'insertion de coefficients du deuxième ensemble entre deux coefficients consécutifs du premier ensemble, définissent un filtre prototype de taille supérieure à celle du filtre prototype initial.

On peut en outre prévoir que ce codeur/décodeur comporte des moyens pour mettre oeuvre le procédé de mise à jour décrit plus haut pour construire le filtre prototype de taille supérieure à celle du filtre prototype initial.

On peut en outre prévoir un procédé de codage/décodage par transformée modulée mis en oeuvre par un codeur/décodeur comportant les étapes :

- obtenir la taille d'une transformée modulée à mettre en oeuvre pour le codage/décodage ;

- si la taille de la transformée est supérieure à la taille d'un filtre prototype initial du codeur/décodeur, mettre à jour la capacité de traitement du codeur/décodeur selon la méthode de mise à jour décrite plus haut;

- coder/décoder le signal au moyen de la transformée modulée en mettant en oeuvre le filtre prototype construit lors de la mise à jour.

Avantageusement, le procédé de codage/décodage est mis en oeuvre par un codeur/décodeur tel que décrit ci-avant.

Un codage/décodage par transformée modulée est un codage/décodage mettant en oeuvre une telle transformée.

L'étape « obtenir la taille d'une transformée » peut par exemple correspondre à la réception d'un signal contenant une information indiquant cette taille. Un tel signal peut par exemple indiquer un mode de codage. Dans ce cas on prévoit un mode basse résolution, avec des trames de données de taille réduite, et donc nécessitant une transformée de taille réduite, et un mode haute résolution avec des trames de données de taille plus grande, nécessitant une transformée de taille plus grande. Néanmoins, on peut aussi prévoir de lire cette information dans un fichier informatique. On peut encore prévoir que cette détermination correspond à une entrée du codeur/décodeur.

Bien entendu, la mise à jour du codeur/décodeur peut aussi s'entendre comme l'initialisation du codeur/décodeur.

Le choix de la taille de la transformée modulée peut également se faire en fonction du nombre d'échantillons, par exemple conditionné par la taille des trames ou des sous-trames à traiter par le codeur/décodeur. En effet, plus le nombre d'échantillon par trame ou sous-trames est grand, plus la taille de la transformée doit être grande.

Ainsi on peut mettre en oeuvre des transformées de tailles variables au cours du temps, les filtres prototypes étant mis à jour au cours du temps, sur la base d'un prototype initial, suivant les besoins.

D'autres caractéristiques et avantages de l'invention apparaîtront à l'examen de la description détaillée ci-après, et des figures annexées parmi lesquelles, en outre la figure 1 :

- la figure 2 illustre l'insertion de coefficients entre deux coefficients consécutifs du filtre initial, pour construire le filtre prototype ;

- la figure 3 illustre un filtre initial et un filtre construit à partir du filtre initial ;

- les figures 4 à 5 illustrent des filtres construits selon différents modes de réalisation de l'invention ;

- la figure 6 illustre un sous-ensemble d'un filtre comportant des coefficients constants ;

- la figure 7 illustre un codeur selon un mode de réalisation de l'invention ;

- la figure 8 illustre les étapes d'un procédé de codage/décodage selon un mode de réalisation de l'invention.

On décrit ci-après une réalisation de l'invention permettant de construire une fenêtre prototype à partir d'une fenêtre prototype correspondant à une transformation de taille inférieure. On se place dans le cadre général des transformées modulées de type ELT, à fenêtres symétriques ou non. Dans le cadre des ELT le filtre prototype a une longueur $L=2KM$ pouvant inclure un certain nombre $M_z$ de zéros en son extrémité, $M$ définissant le nombre de coefficients transformés.

La transformation d'analyse s'écrit :

$$y_{k,m} = \langle x_m, h_k \rangle = \sum_{n=0}^{L-1} x(n+mM) \cdot h(n) \cdot W(k,n) \text{ pour } 0 \le k < M \text{ ,}$$

où

$n$ est un indice temporel correspondant à un multiple de la période d'échantillonnage,

$k$ est un indice représentant un canal fréquentiel considéré,

$h(n)$, $0 \le n < L$, définit le filtre prototype d'analyse,

$W(k,n)$ $0 \le n < L$, définit la fonction modulante pour la fréquence $k$.

La transformation de synthèse s'écrit :

$$\bar{x}(n+mM) = \sum_{k=0}^{M-1} y_{k,m} \cdot f(n) \cdot W(k,n) \text{ pour } 0 \le n < L \text{ ,}$$

où

*f*(*n*) 0≤*n*<*L*, définit le filtre prototype de synthèse,

$\tilde{x}$(*n*) est un signal de longueur L qui contient des termes parasites qui seront supprimés par opération d'addition recouvrement pour obtenir un signal $\hat{x}$*(n)* de durée équivalente à *x*(*n*).

Pour les ELT la modulation *W*(*k,n*) est définie par :

$$W\left(k,n\right) = \cos\left[\frac{\pi}{M}\left(n + \frac{\pm M + 1}{2}\right)\left(k + \frac{1}{2}\right)\right] \; 0 \leq k < M \; \text{ et } \; 0 \leq n < L.$$

Ces transformations permettent d'assurer une reconstruction parfaite c'est-à-dire que $\hat{x}$(*n*) est identique à *x(n)* à un retard près.

Pour assurer une reconstruction parfaite les filtres *f* et *h* doivent satisfaire la contrainte suivante :

$$\sum_{i=0}^{2K-2s-1} f\left(n + iM\right) h\left(n + iM + 2sM\right) = \delta\left(s\right) \; s = 0,1,\ldots,K-1$$

Avec la fonction $\delta$ définie comme $\begin{cases} \delta\left(s = 0\right) = 1 \\ \delta\left(s \neq 0\right) = 0 \end{cases}$

Un mode de réalisation concerne les MDCT c'est-à-dire le sous ensemble des ELT ayant des filtres de longueur *L=2M,* c'est-à-dire avec *K*=1. La condition de reconstruction parfaite s'écrit alors :

$$f\left(n\right)h\left(n\right) + f\left(n + M\right)h\left(n + M\right) = 1 \text{, pour } 0 \leq n < M$$

Une solution consiste à prendre :

$$f\left(n\right) = h\left(2M - 1 - n\right) \text{ pour } 0 \leq n < 2M.$$

Ceci permet d'utiliser les mêmes coefficients de filtre prototype à l'analyse et à la synthèse. Seul un retournement temporel, correspondant au terme *2M-1-n* sera à considérer dans l'algorithme de synthèse.

Dans ce cas, la relation de reconstruction parfaite s'écrit :

$$d\left(n\right) = h\left(n\right)h\left(2M - 1 - n\right) + h\left(n + M\right)h\left(M - 1 - n\right) = 1 \text{ pour } 0 \leq n < M$$

Sur la base de cette transformation de taille *M*, on construit une transformation de taille supérieure pour *M' = U·M*. On définit donc un filtre *h'* dont un certain nombre de coefficients sont issus du filtre *h*.

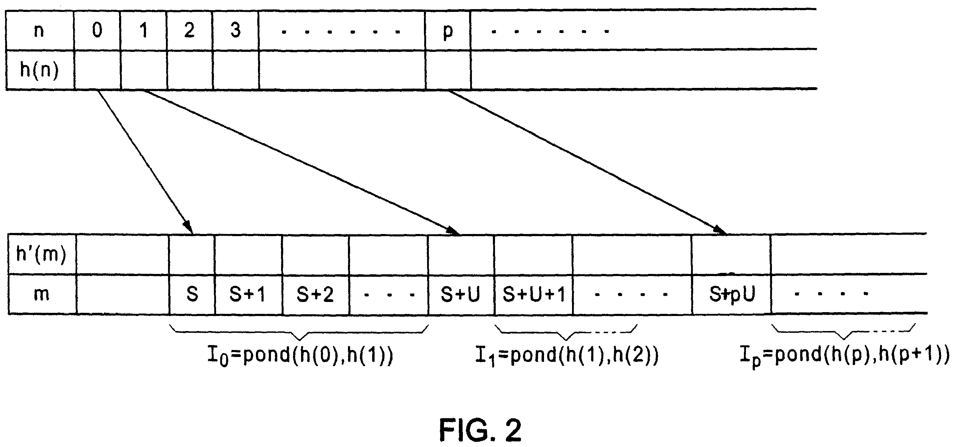

Ainsi, comme représenté sur la figure 2, on construit le filtre *h'* de la façon suivante :

$$h'\left(U \cdot n + S\right) = h\left(n\right) \; 0 \leq n < L.$$

Avec *S* une valeur de décalage, 0≤*S*<*U* .

Afin d'assurer la reconstruction parfaite, le filtre prototype de longueur *L'=2·M'=2·U·M* doit vérifier une relation de reconstruction similaire à celle présentée ci-dessus :

$$\begin{aligned} d'\left(n\right) &= h'\left(n\right)h'\left(2M' - 1 - n\right) + h'\left(n + M'\right)h'\left(M' - 1 - n\right) \\ &= h'\left(n\right)h'\left(2UM - 1 - n\right) + h'\left(n + UM\right)h'\left(UM - 1 - n\right) = 1 \end{aligned} \text{,}$$

sachant que les échantillons d'indice multiple de *U* à la position S sont pris parmi les *h(n).*

On décrit dans la suite des modes de déterminations des valeurs de h' manquantes.

### Mode général

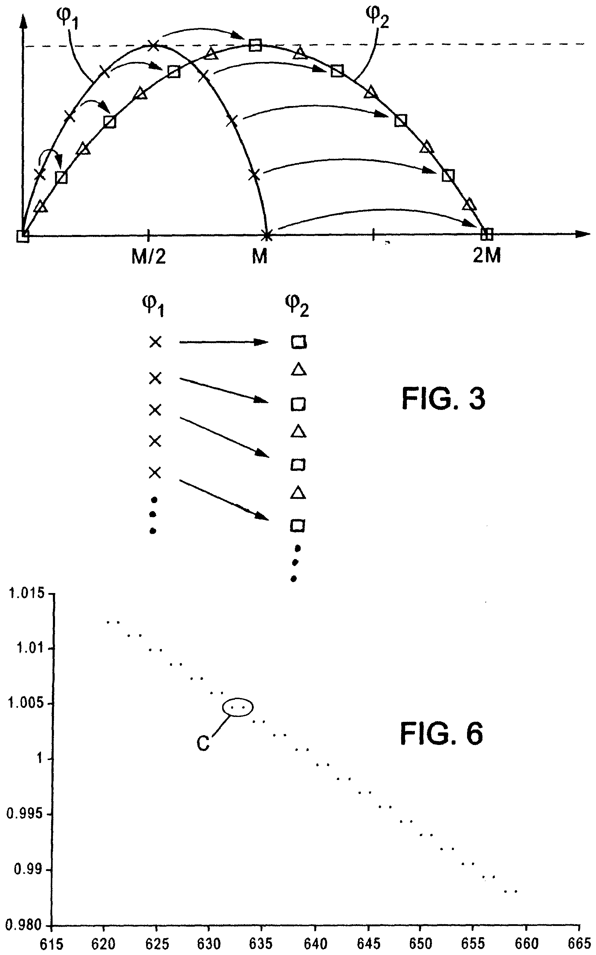

La figure 3 illustre le principe de la détermination du filtre construit. On part d'un filtre $\varphi_1$ de taille M. Ensuite, on redistribue les coefficients de ce filtre $\varphi_1$ sur un intervalle plus grand de taille 2M. Enfin, on calcule les coefficients intermédiaires pour compléter le filtre final $\varphi_2$. Les échantillons intermédiaires, comme sur la figure 2, sont construits suivant l'équation qui définit un mode de réalisation général:

$$h'\left(U \cdot n + S + \delta\right) = P_\delta\left(n\right)h\left(n\right) + Q_\delta\left(n\right)h\left(n+1\right).$$

$P_\delta(n)$ et $Q_\delta(n)$ *avec n<M* , et $\delta$ un entier $0<\delta<U$, sont des fonctions de pondération.

Si S=0 delta initial = 0 et n initial *n0 = 0*

Si S!=0 delta initial =U-S et n initial *n0 = -1*

Ainsi $P_\delta$(-1) et $Q_\delta$(-1) seront définies afin de permettre notamment le calcul de $_h$'(0) = h'(U·(-1)+S+$\delta$) nécessaire quand S est différent de zéro. La première valeur de delta sera $\delta$=U-S.

Il faut noter que l'expression de *h'* peut faire appel à des points non définis. Par exemple h'(U·(2M-1)+S+$\delta$) fait appel à h(2M) qui n'est pas défini.

Pour définir les coefficients manquants, on peut étendre le filtre h dans l'ensemble des formules selon l'une des dispositions suivantes:

- *h*(2*M*+*n*) $\equiv$ -*h*(2*M*-1-*n*)*,* par antisymétrie,

- *h*(2*M*+*n*) $\equiv$ +*h*(2*M*-1-*n*), pour *n*$\geq$0*,* par symétrie,

- *h*(2*M*+*n*) $\equiv$ 0, ajout de coefficients nuls.

De même on peut étendre *h* pour des indices négatifs. Par exemple, pour définir h'(0) il faut définir h(-1). Ainsi, ce coefficient peut être déterminé par extension de h vers les indices négatifs selon l'une des dispositions suivantes :

- *h*(-1-*n*) $\equiv$ -*h*(*n*)*,* par antisymétrie,

- *h*(-1-*n*) $\equiv$ +*h*(*n*), pour *n*$\geq$0, par symétrie,

- *h*(-1-*n*) $\equiv$ 0, par ajout de coefficients nuls.

Dans d'autres cas, les extensions vers les échantillons négatifs et supérieurs à *L* sont réalisées au sens du modulo par duplication multiple du support *0...L-1.*

Pour assurer la reconstruction parfaite de *h'(n),* on réécrit *d'(n)* en un point particulier:

$$d'\left(Un+S\right) = h'\left(Un+S\right)h'\left(2UM-1-Un-S\right) + h'\left(UM+Un+S\right)h'\left(UM-1-Un-S\right) = 1 ,$$

avec

$$d'\left(Un+S\right) =$$
$$h'\left(Un+S\right)h'\left(U(2M-1-n)+U-1-S\right) + h'\left(U(M+n)+S\right)h'\left(U(M-n-1)+U-1-S\right)$$

d'où:

$$h\left(n\right)\left[P_{U-1-2S}\left(M-1-n\right)h\left(2M-1-n\right) + Q_{U-1-2S}\left(M-1-n\right)h\left(2M-n\right)\right]$$
$$+h\left(M+n\right)\left[P_{U-1-2S}\left(M-1-n\right)h\left(M-1-n\right) + Q_{U-1-2S}\left(M-1-n\right)h\left(M-n\right)\right] = 1$$

$$P_{U-1-2S}(M-1-n)\underbrace{\left[h(n)h(2M-1-n)+h(M+n)h(M-1-n)\right]}_{1}+$$

$$Q_{U-1-2S}(M-1-n)\left[h(n)h(2M-n)+h(M-n)h(M+n)\right]=1$$

$$P_{U-1-2S}(M-1-n)=1-Q_{U-1-2S}(M-1-n)\left[h(n)h(2M-n)+h(M-n)h(M+n)\right]$$

ce qui est équivalent à

$$P_{U-1-2S}(n)=1-Q_{U-1-2S}(n)\left[h(M-1-n)h(M+1+n)+h(n+1)h(2M-1-n)\right]$$

En conclusion, étant donné un choix de $Q$ on peut établir une pondération $P$ permettant d'obtenir la reconstruction parfaite.

***Mode de réalisation à pondération unique***

Un mode de réalisation particulier consiste à imposer $P = Q$. Dans ce cas, on peut obtenir une expression directe pour la fonction de pondération :

$$P_{U-1-2S}(n)\left[1+h(n+1)h(2M-1-n)+h(M-1-n)h(M+1+n)\right]=1$$

$$P_{U-1-2S}(n)=\frac{1}{1+h(n+1)h(2M-1-n)+h(M-1-n)h(M+1+n)}$$

On peut écrire $d'$ en un autre point

$$d'(Un+S+1)=$$
$$h'(Un+S+1)h'(2UM-1-Un-S-1)+h'(UM+Un+S+1)h'(UM-1-Un-S-1)=1$$

$$d'(Un+S+1)=$$
$$h'(Un+S+1)h'(U(2M-1-n)+U-S-2)+h'(U(M+n)+S+1)h'(U(M-1-n)+U-S-2)$$
$$=1$$

$$P_1(n)\left[h(n)+h(n+1)\right]h'(U(2M-n-1)+U-S-2)+$$
$$P_{-1}(n)\left[h(M+n)+h(M+n+1)\right]h'(U(M-1-n)+U-S-2)=1$$

$$P_1(n)P_{U-2S-2}(M-1-n)\left[h(n)+h(n+1)\right]\left[h(2M-1-n)+h(2M-n)\right]$$
$$+P_1(n)P_{U-2S-2}(M-1-n)\left[h(M+n)+h(M+n+1)\right]\left[h(M-1-n)+h(M-n)\right]=1$$

$$P_1(n)P_{U-2S-2}(M-1-n)=$$

$$\frac{1}{\left[h(n)+h(n+1)\right]\left[h(2M-1-n)+h(2M-n)\right]+\left[h(M+n)+h(M+n+1)\right]\left[h(M-1-n)+h(M-n)\right]}$$

$$P_1(n) P_{U-2S-2}(M-1-n) =$$

$$\frac{1}{1+h(n)h(2M-n)+h(n+1)\left[h(2M-1-n)+h(2M-n)\right]+h(M+n)h(M-n)+h(M+n+1)\left[h(M-1-n)+h(M-n)\right]}$$

On obtient alors une relation permettant de construire une série de pondération $P_1(n)$ permettant la reconstruction parfaite, à partir d'un $P_{U-2S-2}(M-1-n)$ donné.

Sur base de cette expression on peut généraliser la définition des fonctions de pondération. Elles s'appuieront par paire sous la forme ($\delta \neq 0$):

$$P_\delta(n) P_{U-2S-1-\delta}(M-1-n) =$$

$$\frac{1}{1+h(n)h(2M-n)+h(n+1)\left[h(2M-1-n)+h(2M-n)\right]+h(M+n)h(M-n)+h(M+n+1)\left[h(M-1-n)+h(M-n)\right]}$$

Cette expression permet de générer des pondérations qui construiront le filtre interpolé sous un critère défini.

Par exemple, la réponse fréquentielle de h' sera privilégiée en minimisant son énergie en bande coupée à partir d'une fréquence donnée, en maximisant sa continuité ou son gain de codage vu au travers d'un signal particulier.

### Cas d'interpolation d'ordre 2

Réalisation particulière $U=2, S=0$

Le filtre est interpolé par :

$$h'(2 \cdot n + 0) = h(n)$$

$$h'(2 \cdot n + 1) = P_1(n)h(n) + P_1(n)h(n+1)$$

$$P_1(n) = \frac{1}{1 + h(n+1)h(2M-1-n) + h(M-1-n)h(M+1+n)}$$

$$h'(2 \cdot n + 1) = \frac{h(n) + h(n+1)}{1 + h(n+1)h(2M-1-n) + h(M-1-n)h(M+1+n)} .$$

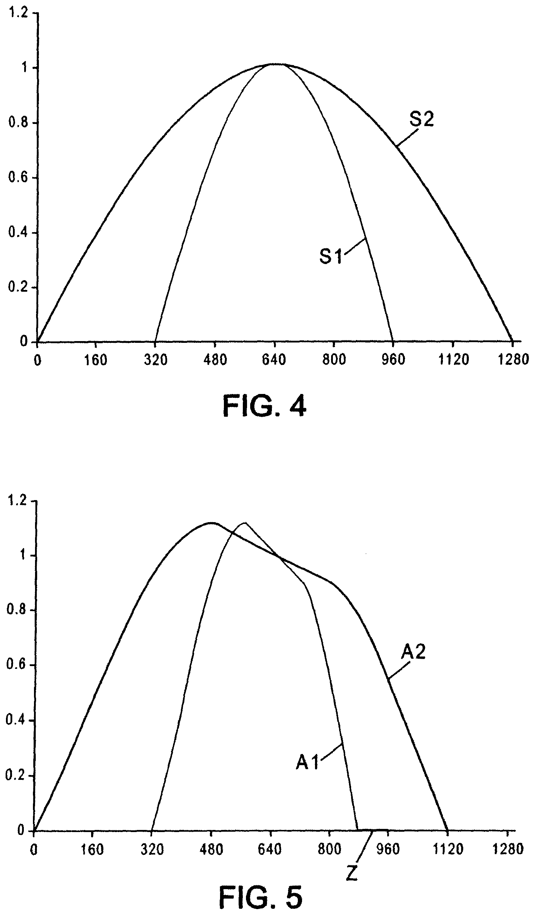

La figure 4 illustre un filtre prototype S1, de type sinusoïdal, de taille 640 pour une MDCT de 320, et un filtre prototype S2 de taille 1280 pour une MDCT de 640 obtenu à partir de S1 selon la présente réalisation particulière (S1 a volontairement été centré autour de 640 pour comparer S1 et S2).

### Cas d'interpolation d'ordre 2 avec zéro en extrémité

Dans un mode de réalisation particulier $h(n)$ incluant des zéros en son extrémité (c'est-à-dire dans des indices consécutifs démarrant en $n=0$, ou en $n=L-1$), sans perte de généralité on aura $h(n) = 0$ pour $2M-Mz \leq n < 2M$. Du fait de l'interpolation proposée, les h' seront alors nuls dans le support correspondant. Une propriété particulière de l'interpolation proposée est la suivante :

$$d'(2n) = h'(2n)\underbrace{h'(4M-1-2n)}_{0} + h'(2M+2n)h'(2M-1-2n) = 1$$

$$h'(2M-1-2n) = \frac{1}{h(M+n)}$$

Or $d(n) = h(n)\underbrace{h(2M-1-n)}_{0} + h(M+n)h(M-1-n) = 1$, donc

$$h(M-1-n) = \frac{1}{h(M+n)}.$$

Ainsi il vient : $h'(2M-1-2n) = \frac{1}{h(M+n)} = h(M-1-n) = h'(2M-2-2n)$.

Ce choix particulier d'interpolation permet d'obtenir des plages de coefficients constants lorsque des zéros sont imposés dans le filtre $h$. Ces plages ont une longueur 2 pour l'exemple. Par généralisation, on montre que pour une interpolation d'ordre $U$, les plages ont une longueur $U$, dans une zone centrée autour de l'indice $n=UM$.

La figure 5 illustre un filtre prototype A1, de type « ald », de taille 640 pour une MDCT de taille 320, et un filtre prototype A2 de taille 1280 pour une MDCT de 640 construit à partir de A1 selon le présent cas. Comme pour la figure 4, A1 a été centré. Le filtre A1 comporte 80 zéro en son extrémité Z. Ainsi, A2 comporte des plages d'échantillons constants de taille 2 du fait que A1 comporte des zéros en son extrémité.

La figure 6 est un zoom sur la zone de A2 comportant des échantillons constants C.

### Mise en oeuvre

Les filtres prototypes construits selon le procédé décrit ci-avant permettent une implémentation rapide.

Dans l'art antérieur, la première étape lors de l'analyse consiste à pondérer les échantillons par la fenêtre de la transformée considérée avant transformation rapide, comme présenté ci-avant.

Ici, du fait de l'interpolation, les coefficients du filtre prototype peuvent être agencés de sorte qu'ils complètent ceux issus de l'ordre inférieur de transformée.

Par exemple pour une interpolation d'ordre $U$ avec un décalage de $S$, on peut écrire :

$$y'_{k,m} = \langle x_m, h'_k \rangle = \sum_{n=0}^{UL-1} x(n+mT) \cdot h'(n) \cdot W'(k,n)$$

$$h'(U \cdot n + S) = h(n)$$

$$h'(U \cdot n + S + \delta) = P_\delta(n)h(n) + Q_\delta(n)h(n+1)$$

$$y'_{k,m} = \langle x_m, h'_k \rangle = \sum_{n=0}^{L-1} x(Un+S+mT) \cdot h'(Un+S) \cdot W'(k,Un+S) +$$

$$\sum_{\substack{\delta=0 \\ \delta \neq S}}^{U-1} \sum_{n=0}^{L-1} x(Un+S+\delta+mT) \cdot h'(Un+S+\delta) \cdot W'(k,Un+S+\delta)$$

$$y'_{k,m} = \langle x_m, h'_k \rangle = \sum_{n=0}^{L-1} x(Un+S+mT) \cdot h(n) \cdot W'(k,Un+S) +$$

$$\sum_{\substack{\delta=0 \\ \delta \neq S}}^{U-1} \sum_{n=0}^{L-1} x(Un + S + \delta + mT) \cdot \left[ P_\delta(n)h(n) + Q_\delta(n)h(n+1) \right] \cdot W'(k, Un + S + \delta).$$

Ainsi, la mémoire du codeur/décodeur pour le filtre prototype peut donc avantageusement être organisée en deux segments: un premier segment contenant les coefficients du filtre prototype initial sur lequel reposera la première pondération $x(Un + S + mT) \cdot h(n)$, et un second segment contenant les coefficients interpolés. Ainsi, on évitera la duplication de l'espace mémoire tout en conservant l'algorithme de calcul rapide. Cette propriété est conservée côté synthèse des sous bandes lors de la transformation inverse.

Dans le cas d'une interpolation basée sur un filtre initial ayant des zéros en extrémité, l'opération de pondération par le filtre de taille supérieur peut donner lieu à une simplification des opérations. En effet, dans la zone centrale autour de $n=UM$ les coefficients du filtre prototype obtenu ont des échantillons constants. Ainsi une factorisation sous la forme :

$$h(M+n) \sum_{\delta=0}^{U-1} \left[ W(k, UM + Un + S + \delta) x(UM + Un + S + \delta) \right]$$

peut être mise en évidence.

Cela permet d'éviter d'une part de stocker les échantillons interpolés identiques au filtre prototype initial, et d'autre part d'économiser des opérations de pondération grâce à la factorisation. Dans la plage d'échantillons concernée, c'est-à-dire la zone centrée autour de $UM$ on épargnera ainsi $(U-1)$ multiplications par échantillon pondéré.

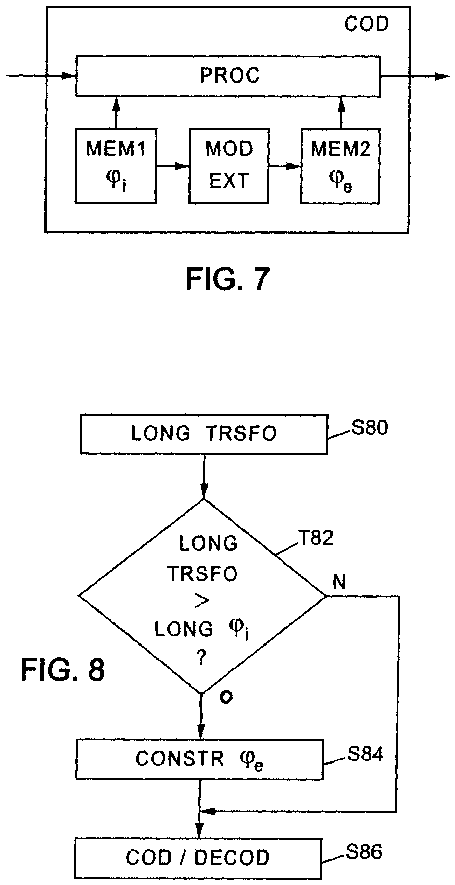

Dans la suite, en référence à la figure 7, on décrit un codeur adapté pour mettre en oeuvre le procédé décrit ci-avant. Un décodeur pourrait avoir la même structure. Le codeur COD comporte une unité de traitement PROC adaptée pour mettre en oeuvre une analyse ou une synthèse de signal, comme cela a déjà été décrit. Pour réaliser ces opérations, le codeur COD s'appuie sur un filtre prototype. Le codeur comporte une première zone mémoire MEM1 pour enregistrer un filtre prototype initial $\varphi_i$. Par exemple, ce filtre initial permet de réaliser des transformations modulée de taille maximale M.

Pour réaliser des transformées modulées de taille supérieure, le codeur comporte une zone mémoire MOD_EXT pour stocker un programme informatique comportant des instructions pour construire un filtre prototype $\varphi_e$ de taille supérieure à $\varphi_i$. Pour cela, on calcule des coefficients additionnels comme décrit plus haut. Ces coefficients additionnels sont ensuite stockés dans une zone mémoire MEM2.

La figure 8 illustre un procédé de codage/décodage qui adapte le filtre prototype utilisé en fonction de la taille souhaitée pour la transformation modulée.

A l'étape S80, on commence par obtenir la taille de la transformée à utiliser pour l'analyse, respectivement la synthèse, du signal à coder, respectivement décoder. Lors du test T82, on détermine si la taille de la transformée modulée est supérieure à la taille d'un filtre prototype $\varphi_i$ stocké en mémoire pour réaliser la transformée modulée.

Si la taille de la transformée modulée est supérieure à la taille du filtre prototype, on passe à l'étape S84 de construction d'un filtre prototype $\varphi_e$ de taille supérieure, comme déjà décrit ci-dessus. Ensuite, à l'étape S86, on réalise le codage, respectivement décodage, du signal.

Si la taille de la transformée est égale à la taille du filtre, on peut passer l'étape S82 de construction, et aller directement à l'étape S86.

Avantageusement, si la transformée a une taille inférieure à celle du filtre, on passe par une étape de réduction de la taille du filtre, par exemple par décimation avant de réaliser l'étape S86.

Bien entendu, la présente invention ne se limite pas aux formes de réalisation décrites ci-avant, elle s'étend à d'autres variantes. Par exemple, on a décrit un calcul de coefficients additionnel par pondération de deux coefficients consécutif, mais on peut envisager d'autres modes de réalisation où la pondération porte sur un nombre plus grand de coefficients.

**Revendications**

1. Procédé de mise à jour de la capacité de traitement d'un codeur (COD) ou décodeur (DECOD) pour mettre en oeuvre une transformée modulée de taille supérieure à une taille prédéterminée, ledit codeur ou décodeur comportant une unité de traitement de signal numérique adaptée pour stocker un filtre prototype initial défini par un ensemble ordonné de coefficients de taille initiale, ledit procédé étant **caractérisé en ce qu'**il comporte une étape de construction d'un filtre prototype de taille supérieure à ladite taille initiale pour mettre en oeuvre la transformée de taille supérieure à la taille prédéterminée, par insertion d'au moins un coefficient entre deux coefficients consécutifs du filtre prototype initial, **en ce que** ledit coefficient inséré entre lesdits deux coefficients consécutifs est calculé par pondération d'au moins lesdits deux coefficients consécutifs et **en ce que**, le filtre prototype vérifiant une relation de reconstruction prédéterminée de type reconstruction parfaite entre un filtre d'analyse et un filtre de synthèse, la pondération est réalisée au moyen d'au moins une fonction de pondération calculée à partir de ladite relation de reconstruction.

2. Procédé selon la revendication 1, **caractérisé en ce que** la fonction de pondération est calculée pour chaque position, entre les deux coefficients consécutifs, du coefficient inséré.

3. Procédé selon la revendication 1, **caractérisé en ce que**

   - la taille du filtre construit h' est U fois plus grande que la taille M du filtre initial h, avec U et M des entiers naturels strictement supérieurs à un ;
   - on définit une valeur de décalage S telle que $0 \leq S < U$, S étant un entier naturel ; et
   - les filtres construit et initial vérifient la relation: $h'(U \times n + S) = h(n)$, pour tout entier naturel n tel que $0 \leq n < M$ .

4. Procédé selon la revendication 1, **caractérisé en ce que**

   - la taille du filtre construit h' est U fois plus grande que la taille M du filtre de base h, avec U et M des entiers naturels strictement supérieurs à un ;
   - on définit une valeur de décalage S telle que $0 \leq S < U$ ;
   - on définit, pour tout entier naturel $\delta$ vérifiant $0 < \delta < U$ deux fonctions de pondération $P_\delta$ et $Q_\delta$,
   - on définit les coefficients insérés par la relation : $h'(U \times n + S + \delta) = P_\delta(n) \times h(n) + Q_\delta(n) \times h(n+1)$, pour tout entier naturel n vérifiant $0 \leq n < M$ ;

   les coefficients du filtre de base h non définis étant nuls ou définis à partir des coefficients du filtre de base h par symétrie ou par antisymétrie.

5. Procédé selon la revendication 4, **caractérisé en ce que** les fonctions de pondération vérifient $P_\delta(n + M) = P_\delta(n)$ et $Q_\delta(n + M) = Q_\delta(n)$ pour tout entier naturel n vérifiant $0 \leq n < M.$

6. Programme informatique comportant des instructions pour la mise en oeuvre du procédé selon la revendication 1 lorsque ce programme est exécuté par un processeur.

7. Codeur (COD) de signaux numériques **caractérisé en ce qu'**il comporte au moins deux zones mémoires (MEM1, MOD_EXT), une première zone mémoire (MEM1) pour stocker un premier ensemble de coefficients définissant un filtre prototype initial ($\varphi_i$) de taille donnée, et une deuxième zone mémoire (MOD_EXT) pour stocker un programme informatique comportant des instructions pour délivrer un deuxième ensemble de coefficients déterminés à partir des coefficients du premier ensemble, l'ensemble formé par l'insertion de coefficients du deuxième ensemble entre deux coefficients consécutifs du premier ensemble, définissant un filtre prototype ($\varphi_e$) de taille supérieure à celle du filtre prototype initial, **en ce que** ledit coefficient inséré entre lesdits deux coefficients consécutifs du premier ensemble est calculé par pondération d'au moins lesdits deux coefficients consécutifs du premier ensemble et **en ce que**, le filtre prototype vérifiant une relation de reconstruction prédéterminée de type reconstruction parfaite entre un filtre d'analyse et un filtre de synthèse, la pondération est réalisée au moyen d'au moins une fonction de pondération calculée à partir de ladite relation de reconstruction.

8. Procédé de codage par transformée modulée mis en oeuvre par un codeur selon la revendication 7, comportant les étapes :

   - obtenir (S80) la taille d'une transformée modulée à mettre en oeuvre pour le codage ;
   - si la taille de la transformée est supérieure à la taille du filtre prototype initial (T82), mettre à jour (S84) la capacité de traitement du codeur;
   - coder le signal au moyen de ladite transformée modulée en mettant en oeuvre le filtre prototype construit lors de la mise à jour (S86).

9. Décodeur (COD) de signaux numériques **caractérisé en ce qu'**il comporte au moins deux zones mémoires (MEM1, MOD_EXT), une première zone mémoire (MEM1) pour stocker un premier ensemble de coefficients définissant un filtre prototype initial ($\varphi_i$) de taille donnée, et une deuxième zone mémoire (MOD_EXT) pour stocker un programme informatique comportant des instructions pour délivrer un deuxième ensemble de coefficients déterminés à partir des coefficients du premier ensemble, l'ensemble formé par l'insertion de coefficients du deuxième ensemble entre deux coefficients consécutifs du premier ensemble, définissant un filtre prototype ($\varphi_e$) de taille supérieure à celle du filtre prototype initial, **en ce que** ledit coefficient inséré entre lesdits deux coefficients consécutifs du premier ensemble est calculé par pondération d'au moins lesdits deux coefficients consécutifs du premier ensemble et **en ce que**, le filtre prototype vérifiant une relation de reconstruction prédéterminée de type reconstruction parfaite entre un filtre d'analyse et un filtre de synthèse, la pondération est réalisée au moyen d'au moins une fonction de pondération calculée à partir de ladite relation de reconstruction.

10. Procédé de décodage par transformée modulée mis en oeuvre par un décodeur selon la revendication 9, comportant les étapes :

- obtenir (S80) la taille d'une transformée modulée à mettre en oeuvre pour le décodage ;
- si la taille de la transformée est supérieure à la taille du filtre prototype initial (T82), mettre à jour (S84) la capacité de traitement du codeur;
- décoder le signal au moyen de ladite transformée modulée en mettant en oeuvre le filtre prototype construit lors de la mise à jour (S86).

**Patentansprüche**

1. Verfahren zur Aktualisierung der Verarbeitungskapazität eines Kodierers (COD) oder Dekodierers (DECOD) zur Durchführung einer modulierten Transformation von einer Größe, die größer als eine vorbestimmte Größe ist, wobei der Kodierer oder Dekodierer eine digitale Signalverarbeitungseinheit aufweist, die dafür ausgelegt ist, ein Anfangs-Prototypfilter zu speichern, das durch eine geordnete Menge von Koeffizienten einer Anfangsgröße definiert ist, wobei das Verfahren **dadurch gekennzeichnet ist, dass** es einen Schritt der Konstruktion eines Prototypfilters von einer Größe, die größer als die Anfangsgröße ist, zur Durchführung der Transformation von einer Größe, die größer als die vorbestimmte Größe ist, durch Einfügen wenigstens eines Koeffizienten zwischen zwei aufeinander folgende Koeffizienten des Anfangs-Prototypfilters aufweist, dadurch, dass der zwischen die zwei aufeinander folgenden Koeffizienten eingefügte Koeffizient durch Gewichtung wenigstens der zwei aufeinander folgenden Koeffizienten berechnet wird, und dadurch, dass, wenn das Prototypfilter eine vorbestimmte Rekonstruktionsbeziehung vom Typ einer perfekten Rekonstruktion zwischen einem Analysefilter und einem Synthesefilter erfüllt, die Gewichtung mittels wenigstens einer Gewichtungsfunktion vorgenommen wird, die aus der Rekonstruktionsbeziehung berechnet wurde.

2. Verfahren nach Anspruch 1, **dadurch gekennzeichnet, dass** die Gewichtungsfunktion für jede Position, zwischen den zwei aufeinander folgenden Koeffizienten, des eingefügten Koeffizienten berechnet wird.

3. Verfahren nach Anspruch 1, **dadurch gekennzeichnet, dass**

- die Größe des konstruierten Filters h' das U-fache der Größe M des Anfangsfilters h beträgt, wobei U und M natürliche Zahlen sind, die streng größer als eins sind;
- ein Verschiebungswert S derart definiert wird, dass $0 \leq S < U$ ist, wobei S eine natürliche Zahl ist; und
- das konstruierte Filter und das Anfangsfilter der Beziehung $h'(U \times n + S) = h(n)$ genügen, für jede natürliche Zahl n mit $0 \leq n < M.$

4. Verfahren nach Anspruch 1, **dadurch gekennzeichnet, dass**

- die Größe des konstruierten Filters h' das U-fache der Größe M des Basisfilters h beträgt, wobei U und M natürliche Zahlen sind, die streng größer als eins sind;
- ein Verschiebungswert S derart definiert wird, dass $0 \leq S < U$ ist;
- für jede natürliche Zahl $\delta$, für die $0 < \delta < U$ ist, zwei Gewichtungsfunktionen $P_\delta$ und $Q_\delta$ definiert werden;
- die eingefügten Koeffizienten durch die Beziehung $h'(U \times n + S + \delta) = P_\delta(n) \times h(n) + Q_\delta(n) \times h(n+1)$ definiert werden, für jede natürliche Zahl n, für die $0 \leq n < M$ ist;

wobei die nicht definierten Koeffizienten des Basisfilters h null sind oder ausgehend von den Koeffizienten des Basisfilters h durch Symmetrie oder durch Antisymmetrie definiert werden.

**5.** Verfahren nach Anspruch 4, **dadurch gekennzeichnet, dass** die Gewichtungsfunktionen die Beziehungen $P_\delta(n+M)$ = $P_\delta(n)$ und $Q_\delta(n+M) = Q_\delta(n)$ erfüllen, für jede natürliche Zahl n, für die $0 \leq n < M$ ist.

**6.** Softwareprogramm, welches Anweisungen zur Durchführung des Verfahrens nach Anspruch 1, wenn dieses Programm von einem Prozessor ausgeführt wird, beinhaltet.

**7.** Kodierer (COD) für digitale Signale, **dadurch gekennzeichnet, dass** er wenigstens zwei Speicherbereiche (MEM1, MOD_EXT) aufweist, einen ersten Speicherbereich (MEM1) zum Speichern einer ersten Menge von Koeffizienten, die ein Anfangs-Prototypfilter ($\varphi_i$) von gegebener Größe definieren, und einen zweiten Speicherbereich (MOD_EXT) zum Speichern eines Softwareprogramms, das Anweisungen zum Liefern einer zweiten Menge von Koeffizienten umfasst, die aus den Koeffizienten der ersten Menge bestimmt werden, wobei die Menge, die durch die Einfügung von Koeffizienten der zweiten Menge zwischen zwei aufeinander folgende Koeffizienten der ersten Menge gebildet wird, ein Prototypfilter ($\varphi_e$) von einer Größe definiert, die größer als diejenige des Anfangs-Prototypfilters ist, dadurch, dass der zwischen die zwei aufeinander folgenden Koeffizienten der ersten Menge eingefügte Koeffizient durch Gewichtung wenigstens der zwei aufeinander folgenden Koeffizienten der ersten Menge berechnet wird, und dadurch, dass, wenn das Prototypfilter eine vorbestimmte Rekonstruktionsbeziehung vom Typ einer perfekten Rekonstruktion zwischen einem Analysefilter und einem Synthesefilter erfüllt, die Gewichtung mittels wenigstens einer Gewichtungsfunktion vorgenommen wird, die aus der Rekonstruktionsbeziehung berechnet wurde.

**8.** Verfahren zur Kodierung durch modulierte Transformation, das von einem Kodierer nach Anspruch 7 durchgeführt wird, die folgenden Schritte umfassend:

- Gewinnen (S80) der Größe einer modulierten Transformation, die für die Kodierung durchzuführen ist;
- falls die Größe der Transformation größer als die Größe des Anfangs-Prototypfilters (T82) ist, Aktualisieren (S84) der Verarbeitungskapazität des Kodierers;
- Kodieren des Signals mittels der modulierten Transformation unter Verwendung des bei der Aktualisierung konstruierten Prototypfilters (S86) .

**9.** Dekodierer (COD) für digitale Signale, **dadurch gekennzeichnet, dass** er wenigstens zwei Speicherbereiche (MEM1, MOD_EXT) aufweist, einen ersten Speicherbereich (MEM1) zum Speichern einer ersten Menge von Koeffizienten, die ein Anfangs-Prototypfilter ($\varphi_i$) von gegebener Größe definieren, und einen zweiten Speicherbereich (MOD_EXT) zum Speichern eines Softwareprogramms, das Anweisungen zum Liefern einer zweiten Menge von Koeffizienten umfasst, die aus den Koeffizienten der ersten Menge bestimmt werden, wobei die Menge, die durch die Einfügung von Koeffizienten der zweiten Menge zwischen zwei aufeinander folgende Koeffizienten der ersten Menge gebildet wird, ein Prototypfilter ($\varphi_e$) von einer Größe definiert, die größer als diejenige des Anfangs-Prototypfilters ist, dadurch, dass der zwischen die zwei aufeinander folgenden Koeffizienten der ersten Menge eingefügte Koeffizient durch Gewichtung wenigstens der zwei aufeinander folgenden Koeffizienten der ersten Menge berechnet wird, und dadurch, dass, wenn das Prototypfilter eine vorbestimmte Rekonstruktionsbeziehung vom Typ einer perfekten Rekonstruktion zwischen einem Analysefilter und einem Synthesefilter erfüllt, die Gewichtung mittels wenigstens einer Gewichtungsfunktion vorgenommen wird, die aus der Rekonstruktionsbeziehung berechnet wurde.

**10.** Verfahren zur Dekodierung durch modulierte Transformation, das von einem Dekodierer nach Anspruch 9 durchgeführt wird, die folgenden Schritte umfassend:

- Gewinnen (S80) der Größe einer modulierten Transformation, die für die Dekodierung durchzuführen ist;
- falls die Größe der Transformation größer als die Größe des Anfangs-Prototypfilters (T82) ist, Aktualisieren (S84) der Verarbeitungskapazität des Kodierers;
- Dekodieren des Signals mittels der modulierten Transformation unter Verwendung des bei der Aktualisierung konstruierten Prototypfilters (S86) .

**Claims**

**1.** Method of updating the processing capacity of a coder (COD) or decoder (DECOD) for implementing a modulated transform of size greater than a predetermined size, said coder or decoder comprising a digital signal processing unit suitable for storing an initial prototype filter defined by an ordered set of coefficients of initial size, said method being **characterized in that** it comprises a step of constructing a prototype filter of size greater than said initial size so as to implement the transform of size greater than the predetermined size, by inserting at least one coefficient between two consecutive coefficients of the initial prototype filter, **in that** said coefficient inserted between said two consecutive coefficients is calculated by weighting at least said two consecutive coefficients and **in that**, the prototype filter satisfying a predetermined reconstruction relation of perfect reconstruction type between an analysis filter and a synthesis filter, the weighting is carried out by means of at least one weighting function calculated on the basis of said reconstruction relation.

2. Method according to Claim 1, **characterized in that** the weighting function is calculated for each position, between the two consecutive coefficients, of the inserted coefficient.

3. Method according to Claim 1, **characterized in that**

   - the size of the constructed filter h' is U times larger than the size M of the initial filter h, with U and M being natural integers strictly greater than one;
   - a shift value S is defined such that $0 \leq S < U$, S being a natural integer; and
   - the constructed and initial filters satisfy the relation: $h'(U \times n + S) = h(n)$, for any natural integer n such that $0 \leq n < M$.

4. Method according to Claim 1, **characterized in that**

   - the size of the constructed filter h' is U times larger than the size M of the base filter h, with U and M being natural integers strictly greater than one;
   - a shift value S is defined such that $0 \leq S < U$;
   - for any natural integer $\delta$ satisfying $0 \leq \delta < U$, two weighting functions $P_\delta$ and $Q_\delta$ are defined,
   - the inserted coefficients are defined by the relation: $h'(U \times n + S + \delta) = P_\delta(n) \times h(n) + Q_\delta(n) \times h(n + 1)$, for any natural integer n satisfying $0 \leq n < M$;

   the undefined coefficients of the base filter h being zero or defined on the basis of the coefficients of the base filter h by symmetry or by antisymmetry.

5. Method according to Claim 4, **characterized in that** the weighting functions satisfy $P_\delta(n + M) = P_\delta(n)$ and $Q_\delta(n + M) = Q_\delta(n)$ for any natural integer n satisfying $0 \leq n < M$.

6. Computer program comprising instructions for the implementation of the method according to Claim 1 when this program is executed by a processor.

7. Coder (COD) of digital signals, **characterized in that** it comprises at least two memory areas (MEM1, MOD_EXT), a first memory area (MEM1) for storing a first set of coefficients defining an initial prototype filter ($\varphi_i$) of given size, and a second memory area (MOD_EXT) for storing a computer program comprising instructions for delivering a second set of coefficients determined on the basis of the coefficients of the first set, the set formed by inserting coefficients of the second set between two consecutive coefficients of the first set, defining a prototype filter ($\varphi_e$) of greater size than that of the initial prototype filter, **in that** said coefficient inserted between said two consecutive coefficients of the first set is calculated by weighting at least said two consecutive coefficients of the first set and **in that**, the prototype filter satisfying a predetermined reconstruction relation of perfect reconstruction type between an analysis filter and a synthesis filter, the weighting is carried out by means of at least one weighting function calculated on basis of said reconstruction relation.

8. Method of coding by modulated transform, implemented by a coder according to Claim 7, comprising the steps:

   - obtaining (S80) the size of a modulated transform to be implemented for coding;
   - if the size of the transform is greater than the size of the initial prototype filter (T82), updating (S84) the processing capacity of the coder;
   - coding the signal by means of said modulated transform by implementing the prototype filter constructed during the updating (S86).

9. Decoder (COD) of digital signals, **characterized in that** it comprises at least two memory areas (MEM1, MOD_EXT), a first memory area (MEM1) for storing a first set of coefficients defining an initial prototype filter ($\varphi_i$) of given size, and a second memory area (MOD_EXT) for storing a computer program comprising instructions for delivering a second set of coefficients determined on the basis of the coefficients of the first set, the set formed by inserting coefficients of the second set between two consecutive coefficients of the first set, defining a prototype filter ($\varphi_e$) of greater size than that of the initial prototype filter, **in that** said coefficient inserted between said two consecutive coefficients of the first set is calculated by weighting at least said two consecutive coefficients of the first set and **in that**, the prototype filter satisfying a predetermined reconstruction relation of perfect reconstruction type between an analysis filter and a synthesis filter, the weighting is carried out by means of at least one weighting function calculated on basis of said reconstruction relation.

10. Method of decoding by modulated transform, implemented by a decoder according to Claim 9, comprising the steps:

- obtaining (S80) the size of a modulated transform to be implemented for decoding;
- if the size of the transform is greater than the size of the initial prototype filter (T82), updating (S84) the processing capacity of the coder;
- decoding the signal by means of said modulated transform by implementing the prototype filter constructed during the updating (S86).

FIG. 1

FIG. 2

FIG. 3

FIG. 6

FIG. 4

FIG. 5

COD

PROC

MEM1
$\varphi_i$

MOD
EXT

MEM2
$\varphi_e$

**FIG. 7**

LONG TRSFO — S80

LONG
TRSFO
>
LONG $\varphi_i$
? — T82

N

**FIG. 8**

O

CONSTR $\varphi_e$ — S84

COD / DECOD — S86

## RÉFÉRENCES CITÉES DANS LA DESCRIPTION

**Documents brevets cités dans la description**

- FR 2828600 A

**Littérature non-brevet citée dans la description**

- **MARTUCCI S A.** *Interpolation in the DST and DCT domains*
- **PINCHON D et al.** *Design Techniques for Orthogonal Modulated Filterbanks based on a Compact Representation*